# EUROPEAN PATENT SPECIFICATION

(11) **EP 4 097 774 B1**
(45) Date of publication and mention of the grant of the patent: **09.09.2026**
(21) Application number: 21703970.0
(22) Date of filing: 29.01.2021
(51) Int. Cl.: H10N 70/20

(54) **MEMRISTOR COMPRISING COMPLEX OXIDE MEMRISTIVE MATERIAL AND FABRICATION THEREOF**
MEMRISTOR MIT EINEM KOMPLEXEN OXIDISCHEN MEMRISTIVEN MATERIAL UND SEINE HERSTELLUNG
MEMRISTANCE COMPRENANT UN MATÉRIAU MEMRISTIF D'OXYDE COMPLEXE ET SA FABRICATION

(30) Priority: 31.01.2020 FI 20205101
(43) Date of publication of application: 07.12.2022
(73) Proprietor: Turun yliopisto, 20014 Turun yliopisto (FI)
(72) Inventor: PATURI, Petriina, 20014 Turun yliopisto (FI); SCHULMAN, Alejandro, 20014 Turun yliopisto (FI); HUHTINEN, Hannu, 20014 Turun yliopisto (FI); LÄHTEENLAHTI, Ville, 20014 Turun yliopisto (FI); BEIRANVAND, Azar, 20014 Turun yliopisto (FI)
(74) Representative: Papula Oy
(86) International application number: PCT/FI2021/050057
(87) International publication number: WO 2021/152215

(56) References cited:
- EP-A1- 1 873 832
- JP-A- 2005 213 078
- US-A1- 2006 050 549
- US-A1- 2009 102 598
- US-A1- 2012 268 980
- PATURI P ET AL: "Room temperature charge-ordered phase in Gd0.6Ca0.4MnO3 and Sm0.6Ca0.4MnO3 thin films", JOURNAL OF MAGNETISM AND MAGNETIC MATERIALS, vol. 432, 2 February 2017 (2017-02-02), pages 164 - 168, XP029949675, ISSN: 0304-8853, DOI: 10.1016/J.JMMM.2017.01.080
- SCHULMAN A ET AL: "Appearance of glassy ferromagnetic behavior in Gd1-xCaxMnO3 (0<=x<=1) thin films: A revised phase diagram", JOURNAL OF MAGNETISM AND MAGNETIC MATERIALS, vol. 498, 166149, 15 November 2019 (2019-11-15), XP086034661, ISSN: 0304-8853, DOI: 10.1016/J.JMMM.2019.166149
- LIN J G ET AL: "Development of random access memory in Nd0.7Ca0.3MnO3/YBa2Cu3O7 heterostructure", THIN SOLID FILMS, vol. 518, no. 20, 2 August 2010 (2010-08-02), pages 5673 - 5675, XP027131838, ISSN: 0040-6090, DOI: 10.1016/j.tsf.2009.10.027

## Description

### FIELD OF THE INVENTION

The invention concerns memristors, i.e. electronic components the current-conducting properties of which depend on electric conditions they have been previously subjected to. In particular the invention concerns a memristor that comprises a complex oxide as the memristive material, said complex oxide comprising gadolinium, calcium and manganese.

### BACKGROUND OF THE INVENTION

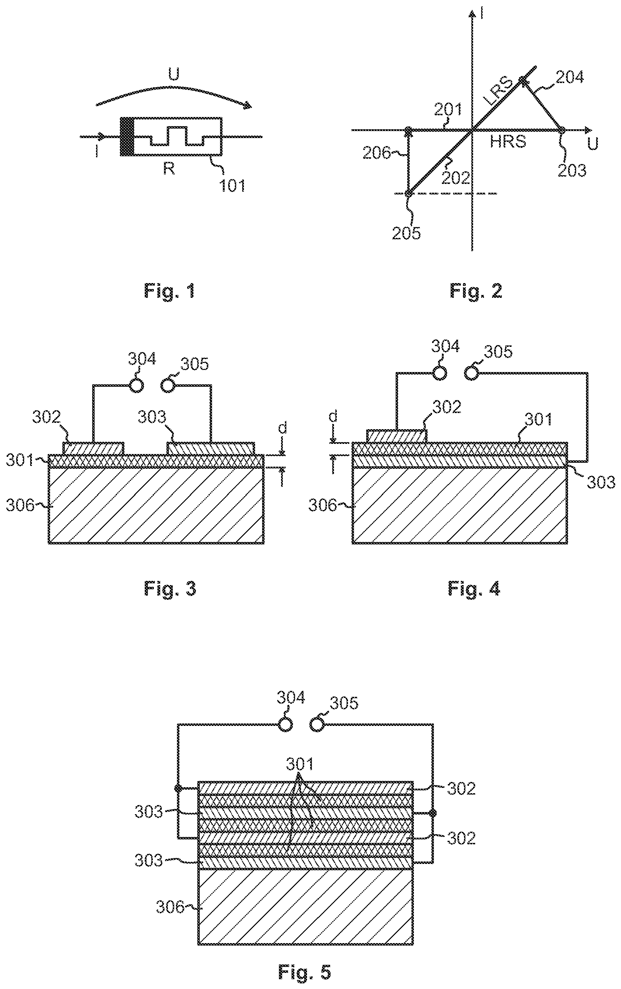

Memristors are electronic components the current-conducting properties of which depend on electric conditions they have been previously subjected to. As an example, fig. 1 illustrates a memristor 101, the resistance of which is marked with R. Instead of resistance one could consider its inverse value, i.e. conductance. A voltage across the memristor 101 is U, and a current through the memristor 101 is I. The memristor 101 may exhibit a so-called high resistivity state HRS or a so-called low resistivity state LRS, somewhat idealized illustrations of which are shown in the current per voltage diagram of fig. 2. The HRS appears as a horizontal line 201 along or very close to the x-axis, meaning that only a very small current flows through the memristor irrespective of the voltage. The LRS state appears as a diagonal line 202, meaning that the current I through the memristor 101 is a linear function of the voltage according to I = U/R.

The memristor 101 of figs. 1 and 2 exhibits bipolar switching between the HRS and the LRS. This means that switching from HRS to LRS takes place at a different polarity of the voltage U than switching from LRS to HRS. In fig. 2, if the memristor is initially in the HRS and the positive voltage across it reaches a first threshold point 203, the memristor switches into the LRS according to arrow 204. If the operation in the negative end of the LRS region reaches a second threshold point 205, the memristor switches back into the HRS according to arrow 206.

A memristor becomes highly interesting for a number of possible applications if the switching between HRS and LRS remains fully reversible even after a large number of cycles, and even more importantly if it can be made to obey a linear relationship between the voltage (or other quantity) used to make the HRS->LRS transition and the resistance R thus obtained. The latter property would mean a kind of analog control of conductance, and it would have interesting applications in neuromorphic computing, in which the conductances of memristors could be used to represent the weights or strengths of synaptic connections between nodes in the neural network. With memristors of prior art it has proven to be difficult to obtain the sufficient linearity. For the purpose of use in microelectronic circuits it should be possible to manufacture the memristor in a thin film form.

Prior art documents that describe relevant background art include P. Paturi, J. Tikkanen, and H. Huhtinen: "Room temperature charge-ordered phase in Gd0.6Ca0.4MnO3 and Sm0.6Ca0.4MnO3 thin films, Journal of Magnetism and Magnetic Materials 432 (2017), 164-168; A. Schulman, A. Beiranvand, V. Lätheenlathi, H. Huhtinen, and P. Paturi: "Appearance of glassy ferromagnetic behavior in Gd1-xCaxMnO3 (0 ≤ x ≤ 1) thin films: A revised phase diagram", Journal of Magnetism and Magnetic Materials 493 (2020), 166149; J.G. Lin, Daniel Hsu, W.F. Wu, C.P. Chang, C.H. Chen: "Development of random access memory in Nd0.7Ca0.3MnO3/YBa2Cu3O7 heterostructure", Thin Solid Films 518 (2010) 5673-5675; and EP 1 873 832 A1.

### SUMMARY

It is therefore an objective to present a thin film material for memristor, and a memristor comprising such material, with which the dependence between the quantity used to establish the LRS conductivity and the conductivity value thus obtained can be made linear.

The objective is achieved by using a low bandwidth perovskite of formula Gd₍₁₋ₓ₎CaₓMnO₃ as the memristor material, where x is larger than 0 but smaller than 1.

According to a first aspect of the present invention there is provided a memristor comprising a piece of memristor material that constitutes at least one memristive connection between first and second contacts. The memristor material has the chemical formula Gd₍₁₋ₓ₎CaₓMnO₃, where x is larger than 0 but smaller than 1. The first contact consists predominantly of a first material and said second contact consists predominantly of a second material different from said first material. The rectifying properties of the junction between the first material and the memristor material are different from the rectifying properties of the junction between the second material and the memristor material.

According to an embodiment of the first aspect said x is in one of the following ranges: 0.31-0.99, 0.35-0.99, 0.4-0.98, 0.45-0.97, 0.5-0.96, 0.55-0.95, 0.6-0.95, 0.65-0.95, 0.7-0.95, 0.75-0.95, 0.8-0.95, 0.85-0.95.

According to an embodiment of the first aspect the piece of memristor material constitutes a film on top of a substrate, wherein a thickness of the film in a direction perpendicular to a surface of said substrate is between 1 nanometre and 500 nanometres.

According to an embodiment of the first aspect said thickness of the film is between 10 and 100 nanometres.

According to an embodiment of the first aspect the first material is one of: aluminium, titanium.

According to an embodiment of the first aspect the second material is one of: gold, silver, copper, platinum, palladium, indium, SrRuO₃.

According to an embodiment of the first aspect said substrate consists predominantly of one of: strontium titanate SrTiO₃, silicon, lanthanum aluminate - strontium aluminium tantalite (LaAlO₃)_{0.3}(Sr₂TaAlO₆)_{0.7}(LSAT), lanthanum aluminate LaAlO₃(LAO).

According to a second aspect of the present invention there is provided a microelectronic circuit comprising at least one memristor of the kind described above.

According to a third aspect of the present invention there is provided a method for manufacturing a memristor of a memristor material. The method comprises using Gd₍₁₋ₓ₎CaₓMnO₃ as the memristor material, where x is larger than 0 but smaller than **1.** The method comprises producing electrically conductive first and second contacts on at least one surface of the memristor material. Said first contact consists predominantly of a first material and said second contact consists predominantly of a second material different from said first material. The rectifying properties of the junction between the first material and the memristor material are different from the rectifying properties of the junction between the second material and the memristor material.

According to an embodiment of the third aspect the method comprises depositing a thin film of said memristor material on top of a substrate.

According to an embodiment of the third aspect the method comprises using, for said depositing, at least one of: pulsed laser deposition, other physical vapor deposition, sputtering, chemical vapor deposition, printing.

According to an embodiment of the third aspect the method comprises
- producing a dry mixture by mixing a first amount of an oxide of gadolinium, a second amount of calcium carbonate, and a third amount of an oxide of manganese,
- pelletizing and calcinating said dry mixture,
- grinding, repelletizing, and sintering into a solid target, and
- using pulsed laser deposition for said depositing, and using said solid target as a target onto which a pulsed laser is focused in said pulsed laser deposition.

According to an embodiment of the third aspect the method comprises using a XeCl-laser of wavelength 308 nanometres with energy density of essentially 2 J/cm² and frequency of 5 Hz in said pulsed laser deposition.

According to an embodiment of the third aspect the deposition temperature is 700 °C and an oxygen partial pressure is essentially 23 Pa in said pulsed laser deposition.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**Figure 1** illustrates a memristor represented by a drawing symbol,
**figure 2** illustrates a dependence between voltage and current in high and low resistivity states of a memristor,
**figure 3** illustrates a memristor of a planar type,
**figure 4** illustrates a memristor of a transversal type,
**figure 5** illustrates a memristor of a multilayer type,
**figure 6** illustrates a pulse train that can be used to characterize a memristor,
**figure 7** illustrates an idealized resistance of a memristor as a function of the voltage used to set the memristor into a particular resistance state,
**figure 8** illustrates an example of a measured resistance of a memristor as a function of the voltage used to set the memristor into a particular resistance state,
**figure 9** illustrates a measured resistance of a memristor made of a first material,
**figure 10** illustrates a measured resistance of a memristor made of a second material,
**figure 11** illustrates a measured resistance of a memristor made of a third material,
**figure 12** illustrates a measured resistance of a memristor made of a fourth material,
**figure 13** illustrates a measured resistance of a memristor made of a fifth material,
**figure 14** illustrates a measured resistance of a memristor made of a sixth material,
**figure 15** illustrates a measured resistance of a memristor made of a seventh material,
**figure 16** illustrates a measured resistance of a memristor made of an eighth material,
**figure 17** illustrates a measured resistance of a memristor made of a ninth material,
**figure 18** illustrates a measured resistance of a memristor made of a tenth material,
**figure 19** illustrates a measured resistance of a memristor made of an eleventh material,
**figure 20** illustrates a measured resistance of a memristor made of a twelfth material,
**figure 21** illustrates measured switching ratios of memristors made of different materials,
**figure 22** illustrates a measured current through a memristor with contacts made of a different materials,
**figure 23** illustrates a manufacturing method,
**figure 24** illustrates a detailed step of the method of fig. 23,
**figure 25** illustrates a pulse train that can be used to characterize a linear response of a memristor,
**figure 26** illustrates another pulse train that can be used to characterize a linear response of a memristor,
**figure 27** illustrates measured results of a transformation with different write pulse lengths and amplitudes.

### DETAILED DESCRIPTION

Fig. 3 is a schematic cross section of a memristor, which here is of the so-called planar type. The memristor comprises a piece of memristor material 301 that constitutes a memristive connection between a first contact 302 and a second contact 303. The expression "memristor material" is used here for the purpose of unambiguously referring to the material that appears between the contacts, although it is the current understanding that the memristor-type effects actually arise in the junction or interface between the memristor material and the contact, not in the bulk of the memristor material itself. Electrically conductive connections couple the first and second contacts 302 and 303 to respective nodes 304 and 305, which can be used to subject the piece of memristor material 301 to desired voltages and to measure the resulting electric characteristics of the piece of memristor material 301.

The piece of memristor material 301 constitutes a film on top of a substrate 306. In a memristor of the planar type, like the one shown in fig. 3, the piece of memristor material 301 can be deposited in the form of a film directly on the surface of the substrate 306, but this is not a requirement; intermediate layers of desired materials can be used therebetween if they are advantageous for example for achieving better compatibility between crystal structures of the various materials involved.

Fig. 4 is a schematic cross section of a memristor, which here is of the so-called transversal type, sometimes also referred to as the capacitor type. Also in this case the piece of memristor material 301 constitutes a memristive connection between a first contact 302 and a second contact 303, and electrically conductive connections couple these to respective nodes 304 and 305. The piece of memristive material 301 constitutes a film that is on top of the substrate 306, but not directly on top thereof because the second contact 303 constitutes a layer therebetween. A memristor of the transversal type like the one shown here has certain advantageous features in comparison with the planar type of fig. 3: for example, it may require lower operating voltages. However, its manufacturing also requires more steps than the manufacturing of a memristor of a planar type.

Fig. 5 is a schematic cross section of a memristor of the multilayer type. In this case there are two or more pieces of memristor material 301, each of which may be sandwiched between other layers. In the exemplary structure shown in fig. 5 the intermediate layers are layers of the first and second contacts 302 and 303, so that each piece of memristor material 301 has a first contact layer on its one side and a second contact layer on its other side in the trans-versal direction, i.e. the direction perpendicular to the surface of the substrate 306.

In all these and other example embodiments where the piece of memristive material constitutes a film on top of a substrate, a thickness d of the film in a direction perpendicular to the surface of the substrate may be for example between 1 and 500 nanometres, or in one preferred embodiment between 10 and 100 nanometres. The thickness d of the film does not need to be constant across its whole area, but in many deposition methods that can be used to produce thin films of this kind a constant thickness of the film is a relatively common default feature of the method.

The first and second contacts 302 and 303 may be made of the same material, outside the present invention, or they are made of different materials, as in embodiments of the present invention.

Saying that a contact is made of a particular material is synonymous to saying that the respective contact consists predominantly of that material, to the extent that the characteristics of that material dominate the effects that are observed at the interface between the contact and the piece of memristive material. In a number of embodiments that have been found to exhibit interesting characteristics the first and second materials are different materials. In particular, it has been found that the memristor may exhibit certain interesting characteristics if the rectifying properties of the junction between the first material and the memristive material are different from the rectifying properties of the junction between the second material and the memristive material.

An example of a material that can be used as the first material is aluminium. Other examples of materials that can be used as the first material exist as well, and include but are not limited to titanium.

Examples of materials that can be used as the second material are gold and silver. Other examples of materials that can be used as the second material exist as well, and include but are not limited to copper, platinum, palladium, indium, and SrRuO₃.

The typical property of a memristor is that its current-conducting properties depend on electric conditions it has been previously subjected to. In this description of particular interest are memristors that can be "programmed" to have a certain resistance value by applying a "write" pulse of a certain amplitude. Even more interesting are memristors that have a linear or log-linear response to write pulses of different amplitudes. This concept is described in more detail in the following.

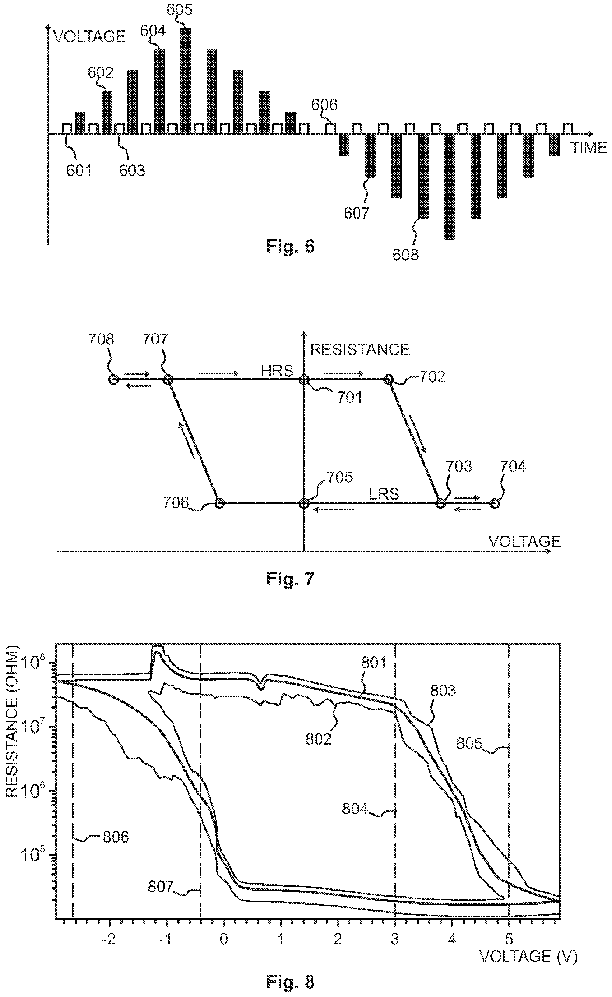

Fig. 6 illustrates a train of voltage pulses, in which the low pulses marked with white are so-called read pulses and the higher pulses marked with black are so-called write pulses. Fig. 7 illustrates how the resistance of a memristor could ideally behave when subjected to a pulse train like that in fig. 6. The voltage axis in fig. 7 corresponds to the amplitude of the last write pulse that the memristor has been subjected to. Each read pulse gives a point on the loop-formed graph of fig. 7. As such, the resistance of the memristor can be read both during a currently ongoing write pulse and during the subsequent read pulse; in ideal case these readings should give the same resistance value. In reality the pulse train may comprise a very much larger number of write pulses at a very much finer resolution, but the illustration in fig. 6 gives a good conceptual view of how characterizing the memristor may proceed.

Assuming that the memristor is initially in its high resistance state HRS, the first read pulse gives the point 701 in fig. 7. A number of write pulses of increasing amplitude may pass without a change in the resistance of the memristor, because there may be a first threshold write voltage that is required to cause any change in its current-conducting properties. Here it is assumed that the second write pulse 602 is just at the limit of the first threshold write voltage, so the subsequent read pulse 603 still gives the HRS resistance value at point 702.

The region of linear or log-linear response begins from point 702 so that each write pulse of increasing amplitude after that makes the memristor assume an unambiguously corresponding, increasingly lower resistance. Due to the coarse resolution of the schematic pulse train in fig. 6 there are not many such pulses shown, but as explained earlier the actual resolution that can be achieved in a real measurement may be much better.

At some point a second threshold write voltage is reached, after which the memristor does not assume any lower resistance even if the amplitude of the write pulses would be increased further. In fig. 6 the write pulse marked as 604 is shown as reaching the second threshold write voltage, corresponding to point 703 in fig. 7. The next write pulse 605 has an even larger amplitude, but the resistance of the memristor does not change any more, as shown by point 704 in fig. 7.

After the largest-amplitude positive write pulse 605 the amplitude of the write pulses in fig. 6 begins to decrease towards zero. In the graph of fig. 7 it is assumed that write pulses of increasingly lower amplitude do not change the resistance of the memristor, so that the read pulse 606 that follows the write interval where actually no write pulse occurs gives point 705 in the graph of fig. 7.

In the ideal case of fig. 7 the behavior of the memristor in response to write pulses of negative polarity is similar to that with write pulses of positive polarity, although e.g. the selection of the contact materials may cause significant differences in factors such as the absolute magnitude of the threshold voltages. In the idealized example of figs. 6 and 7 the first few write pulses of negative polarity still make no change to the LRS resistance of the memristor, until there comes a write pulse 607 the amplitude of which just meets a third threshold write voltage at point 706. A region of linear or log-linear response follows, until the amplitude of a yet further write pulse 608 reaches a fourth threshold write voltage at point 707. Even if write pulses of increasingly larger negative amplitude would follow, the resistance of the memristor would not increase further but would remain constant on the HRS level, as shown by point 708 in fig. 7. The remaining write pulses in the sequence shown in fig. 6 have smaller and smaller negative amplitudes, corresponding returning towards the initial point 701 on the upper horizontal section of the loop-formed graph in fig. 7.

Subjecting a real memristor to a pulse train resembling that of fig. 6 and repeatedly reading its resistance seldom gives a graph as idealized as in fig. 7. However, sufficiently close resemblance has been found with memristors in which the memristor material has the chemical formula Gd₍₁₋ₓ₎CaₓMnO₃, where x is larger than 0 but smaller than 1, in accordance with the present invention. Fig. 8 illustrates an example of one such real-life measurement. The memristor in question was subjected to repeated measurement rounds, in which a pulse train resembling that of fig. 6 was repeated a large number of times. The thick graph 801 in fig. 8 illustrates an arithmetic mean of all loop-formed graphs that resulted in the performed measurements, while the thin graphs 802 and 803 illustrate limits within which the loop-formed graphs of all measurements were contained. The two vertical dashed lines 804 and 805 on the right in fig. 8 delineate a first region of essentially linear or log-linear response, and the other two vertical dashed lines 806 and 807 delineate a second region of essentially linear or log-linear response.

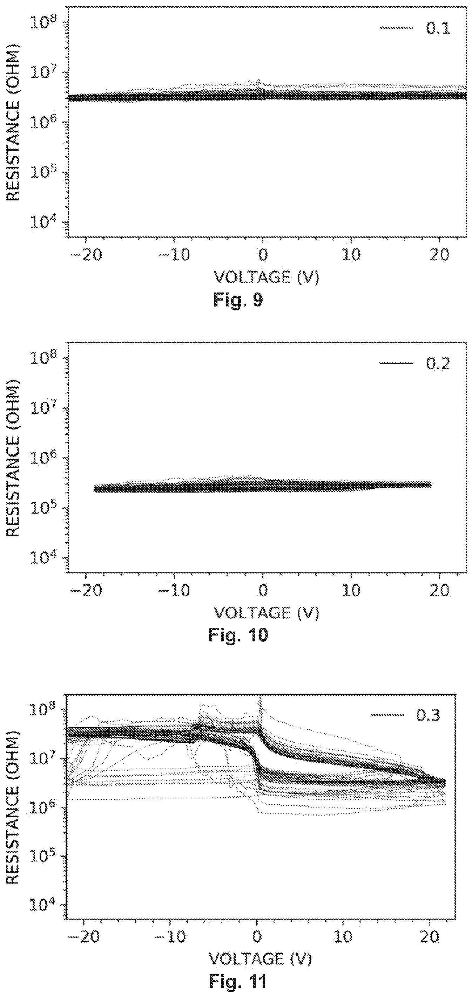

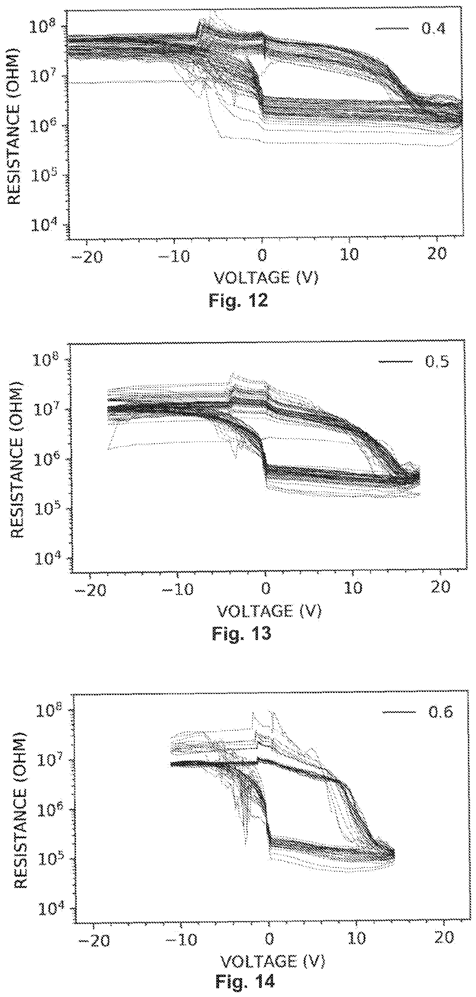

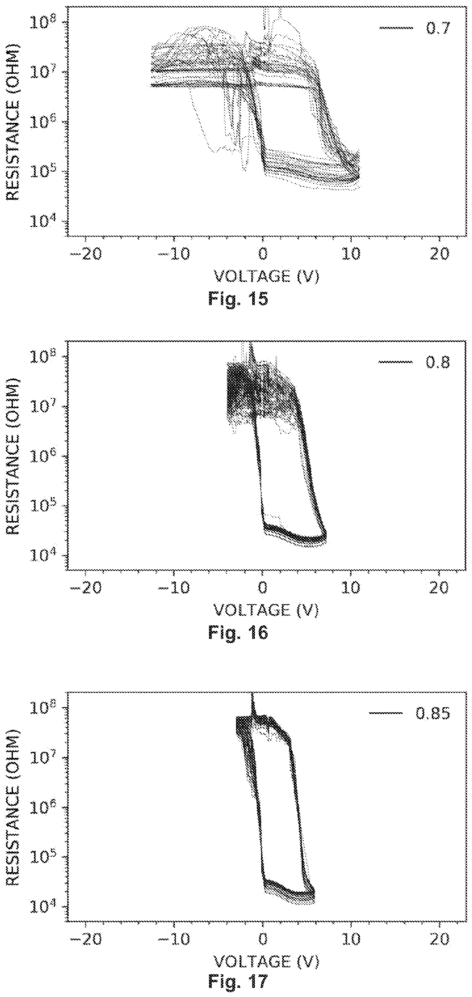

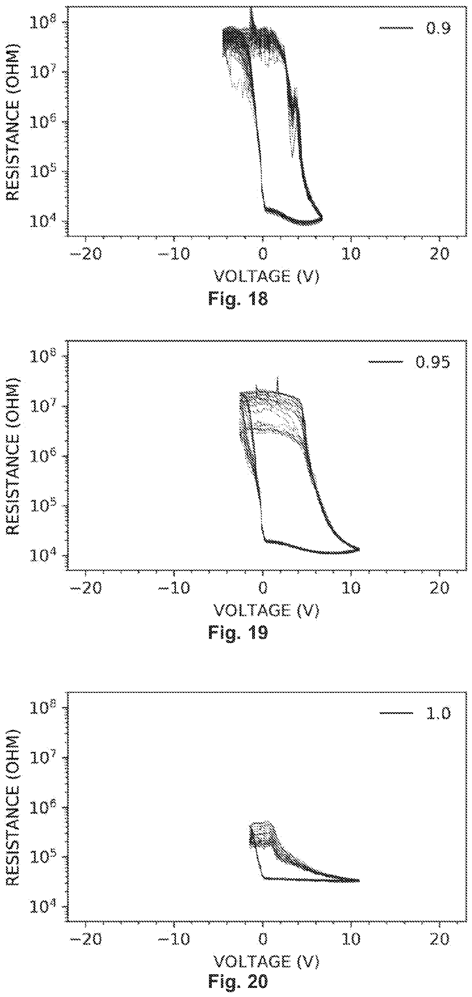

Figs. 9-20 illustrate further results from measurements like that described above, the difference being in the value of the variable x in the compound Gd₍₁₋ₓ₎CaₓMnO₃ that was used as the memristive material. The values of x are 0.1 in fig. 9, 0.2 in fig. 10, 0.3 in fig. 11, 0.4 in fig. 12, 0.5 in fig. 13, 0.6 in fig. 14, 0.7 in fig. 15, 0.8 in fig. 16, 0.85 in fig. 17, 0.9 in fig. 18, 0.95 in fig. 19, and 1.0 in fig. 20. In each of figs. 9-20 the horizontal axis shows the voltage of the write pulses in volts, and the vertical axis shows the measured resistance of the memristor in ohms. It can be seen that the value of x has a pronounced effect on the characteristic behavior of the memristor. Most advantageous response of the memristor to the applied write pulses was found with values of x larger than 0.3. Classes of embodiments with different levels of advantageousness were found when x was in one of the following ranges: 0.31-0.99, 0.35-0.99, 0.4-0.98, 0.45-0.97, 0.5-0.96, 0.55-0.95, 0.6-0.95, 0.65-0.95, 0.7-0.95, 0.75-0.95, 0.8-0.95, 0.85-0.95.

Another characteristic that can be seen in at least some of figs. 9-20 is a so-called cumulative effect of write pulses even after the write pulse of largest amplitude has passed already. For example in the lower right part of the loop-formed graphs of fig. 19 it can be seen that once the voltage values begin to decrease from the maximum of about 11 V, the graphs do not continue directly horizontally to the left but make a bend towards even somewhat smaller resistance values between decreasing amplitude values of the most recent write pulse from said about 11 V to about 2 V. This cumulative effect of the write pulses may be advantageous in some applications in which there is value in the capability of tracking the occurrence of smaller amplitude pulses after larger amplitude ones.

In addition to the linear or log-linear response of the memristor to the amplitude of applied write pulses, another quantity of interest is the switching ratio, defined as a ratio Rmax/Rmin. Here Rmax means the HRS resistance and Rmin means the LRS resistance of the memristor that can be observed with a read pulse after a complete loop of write pulses have been applied. In the idealized case of fig. 7 the value Rmax would be the resistance reading at point 701, and the value Rmin would be the resistance reading at point 705. The larger the switching ratio, the easier it may be to utilize the memristor in practical applications like neuromorphic computing, because the required resolution in a quantity like e.g. the connection strength between nodes of a neural network does not need to be that fine.

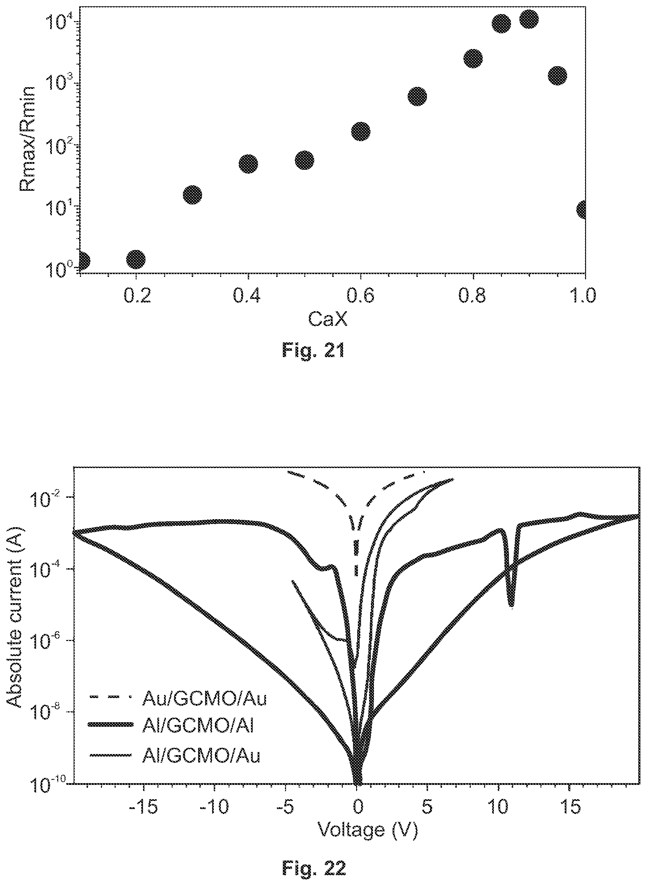

Fig. 21 illustrates the switching ratios that were obtained by producing memristors of the memristor material mentioned above with x=0.1, x=0.2, x=0.3, x=0.4, x=0.5, x=0.6, x=0.7, x=0.8, x=0.85, x=0.9, x=0.95, and x=1 (the black dots from left to right in fig. 21). These measurements suggest that with values of x less than 0.2 it may be difficult to obtain a switching ratio sufficient for many practical applications known at the time of writing this description, while with values of x increasing towards 0.9 increasingly larger switching ratios can be obtained with values such as even four orders of magnitude or more being possible to achieve.

Possible materials for the contacts were discussed briefly earlier in this text. Fig. 22 illustrates a comparison of measured current values through the memristor with both contacts made of gold (dashed line), both contacts made of aluminium (thick solid line) and one contact made of aluminium and one of gold (thin solid line). The rectifying properties of the junction between aluminium and the memristive material are different from the rectifying properties of the junction between gold and the memristive material, which appears to cause the large differences in the measurements shown in fig. 22.

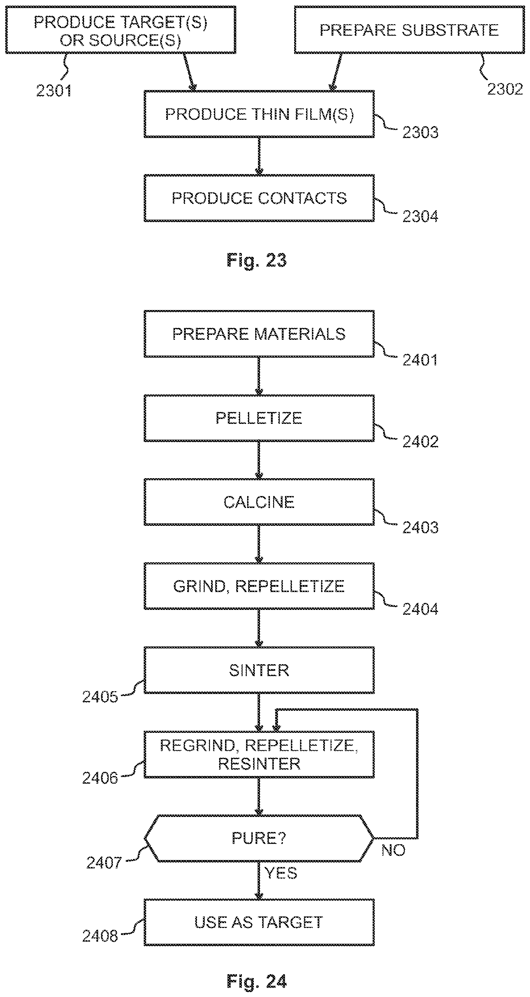

Fig. 23 illustrates a method for manufacturing a memristor of a memristor material of a kind described above. Here it is assumed that in the method the memristive material will be deposited on top of a substrate, but other ways of manufacturing the memristor are not excluded either. Step 2301 represents one or more preparatory steps that aim at providing the memristor material in the form of a target or source that can be used in a thin film depositing technique such as pulsed laser deposition, molecular beam epitaxy, electron beam evaporation, or the like. Also other targets or sources may be produced at step 2301, for example if the memristor structure is to comprise auxiliary layers such as contacts, insulators, and/or the like. Step 2302 represents one or more preparatory steps that aim at providing a substrate on top of which the memristor material can be deposited. Step 2303 represents producing one or more thin films on top of the substrate so that at least one of such thin films comprises the memristor material. The production of contacts to the memristor material is shown as a separate step 2304 in fig. 23. As an example, if pulsed laser deposition is used as the method of depositing the memristor material, DC magnetron sputtering with shadow mask(s) can be used to deposit the layers of the first and possibly second contact material that are to constitute the contacts to the memristive material.

Fig. 24 illustrates an example of how the preparation of a target in step 2301 of fig. 23 may look like. In the example embodiment of fig. 24 the first step 2401 represents initially preparing component materials such as gadolinium(III) oxide, calcium carbonate, and manganese(IV) oxide in suitable amounts for example by drying them overnight in hot (like 200°C) air and mixing the dried component materials in a mortar. The relative amounts of the component material containing gadolinium and the component material containing calcium will eventually define the value of x in the completed target material Gd₍₁₋ₓ₎CaₓMnO₃. Step 2402 represents pelletizing the mixture of component materials, and step 2403 represents calcination of the pelletized mixture for example by using a 7.5 hours - 60 hours pass of temperature 25°C -> 750°C -> 25°C in air. Step 2404 represents grinding the outcome of step 2403 in a mortar and repelletizing. Step 2405 represents sintering for example by using a 13 hours - 24 hours pass of temperature 25°C -> 1300°C -> 25°C in air. Step 2406 represents grinding the outcome of step 2405 in a mortar, repelletizing, and resintering into a solid target or source. Step 2407 represents using X-ray diffraction to measure the outcome of step 2406 and performing Rietveld refinement. If the material is not found to be pure enough, a return to step 2406 occurs. A solid target or source that is found to exhibit sufficient purity in step 2407 may be used as a target or source in a thin film deposition process according to step 2408, for example using said solid target as a target onto which the pulsed laser is focused in pulsed laser deposition. As an example, a XeCl-laser of wavelength 308 nanometres with energy density of essentially 2 J/cm2 and frequency of 5 Hz can be used in said pulsed laser deposition. Examples of process parameter values in such pulsed laser deposition are a deposition temperature of 700 °C and an oxygen partial pressure of essentially 23 Pa. The values of laser energy density, laser pulse frequency, deposition temperature, and oxygen partial pressure given here are just examples, and many other combinations of many other values of these parameters could be utilized.

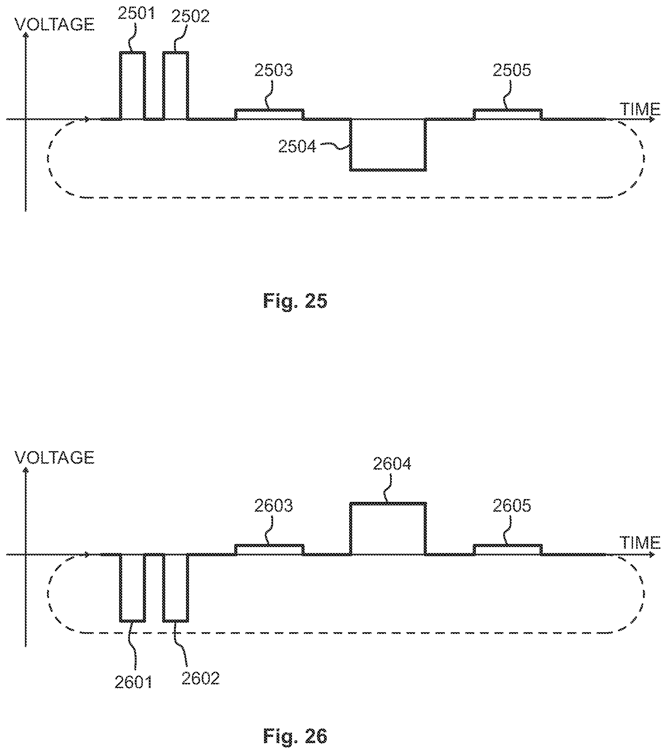

Figs. 25 and 26 illustrate examples of pulse trains that can be used to characterize a linear response of a memristor of the kind described above. In fig. 25 the linear response in an LRS -> HRS transition can be examined. The pulse train begins with two so-called reset pulses 2501 and 2502, the polarity of which is chosen so that they convincingly set the memristor in the low resistivity state LRS. The amplitude of the reset pulses 2501 and 2502 may be for example in the order of +7 V, assuming that the memristor is of the planar type, that the value x in the memristor material is between 0.7 and 0.95, and that one of the contacts is made of gold and the other of aluminium. The length of each of the reset pulses 2501 and 2502 may be for example in the order of 0.45 ms, but also significantly shorter or longer reset pulses are possible: a useful length of a reset pulse may be between 100 ns and 2 ms, or even shorter, like 100 ps. A pause of the order of 5 ms may be had between the reset pulses 2501 and 2502.

A first read pulse 2503 may be applied in order to check through measurement that the memristor is truly in the LRS. The amplitude of the read pulse 2503 may be for example in the order of +0.45 V; in any case it should be selected low enough to ensure that the read pulse does not cause any significant change in the LRS of the memristor. The time interval between the later reset pulse 2502 and the read pulse 2503 may be for example in the order of 0.5 s, or between 0.1 s and 1 s, and the duration of the read pulse 2503 may be for example in the order of 0.5 s. What is described here as a single read pulse may in practice be a series of read pulses, like 20 read pulses, so that the average read value of the LRS resistance is calculated from the readings given by individual pulses.

A write pulse 2504 may be applied in order to make the memristor undergo a transition from the LRS to a higher resistance state. For the purposes of characterizing linear response, and assuming the structural and material-related factors of the memristor named above, the amplitude of the write pulse 2504 may be varied between for example -1 V and -6.5 V. The length of the write pulse 2504 may be varied for example between 50 and 250 ms, but also significantly shorter write pulses can be applied, for example in the order of 100 ns. After the write pulse 2504 a further pause of for example 1 s may be had, and a further read pulse 2505 may be applied to read the transformed resistance of the memristor. Again, what is described here as a single read pulse may in practice be a series of read pulses, like 20 read pulses, so that the average read value of the transformed resistance is calculated from the readings given by individual pulses. Thereafter a return to the beginning of the pulse train may occur, and another pulse train, possibly with some other amplitude and/or duration of the write pulse 2504, may be applied.

In fig. 26 the linear response in an HRS -> LRS transition can be examined. The pulse train begins again with two so-called reset pulses 2601 and 2602, the polarity of which is this time chosen so that they convincingly set the memristor in the high resistivity state HRS. The amplitude of the reset pulses 2601 and 2602 may be for example in the order of -7.6 V, assuming that the memristor is of the planar type, that the value x in the memristor material is between 0.7 and 0.95, and that one of the contacts is made of gold and the other of aluminium. The length of each of the reset pulses 2601 and 2602 may be for example in the order of 1.4 ms, or between 0.1 ms and 2 ms. A pause of the order of 5 ms may be had between the reset pulses 2601 and 2602.

A first read pulse 2603 may be applied in order to check through measurement that the memristor is truly in the HRS. The amplitude and other characteristics of the read pulse 2603 (or sequence of first read pulses) may be similar to those of the first read pulse (or sequence of first read pulses) in fig. 25.

A write pulse 2604 may be applied in order to make the memristor undergo a transition from the HRS to a lower resistance state. For the purposes of characterizing linear response, and assuming the structural and material-related factors of the memristor named above, the amplitude of the write pulse 2604 may be varied between for example +3.5 V and +5.5 V and the length of the write pulse 2604 may be varied for example between 20 and 120 ms. After the write pulse 2604 a further pause of for example 0.5 s may be had, and a further read pulse 2605 may be applied to read the transformed resistance of the memristor. Again, what is described here as a single read pulse may in practice be a series of read pulses, like 20 read pulses, so that the average read value of the transformed resistance is calculated from the readings given by individual pulses. Thereafter a return to the beginning of the pulse train may occur, and another pulse train, possibly with some other amplitude and/or duration of the write pulse 2604, may be applied.

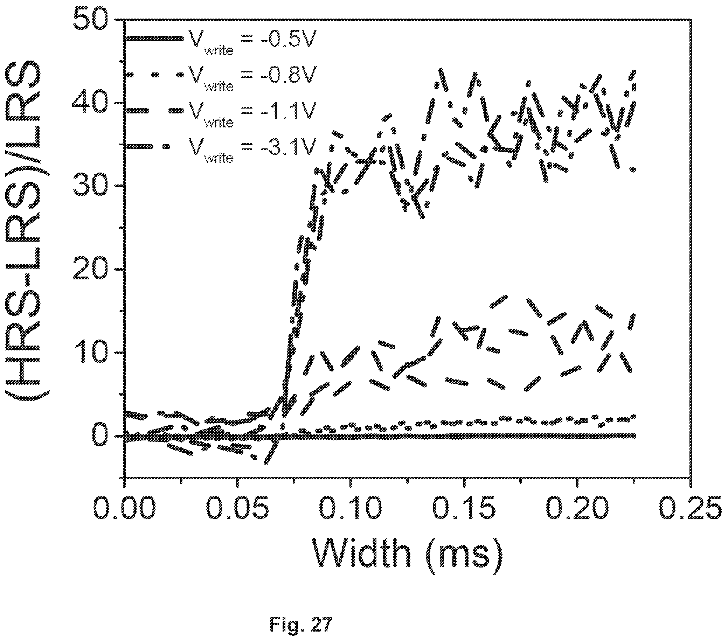

Fig. 27 shows measured results of the ratio (HRS-LRS)/LRS, with different amplitudes and durations of write pulses. Each individual graph in fig. 27 represents a write pulse amplitude according to the associated legend, and the horizontal axis represents the width of the respective write pulse in milliseconds. These measurements show that both the amplitude and the duration in time of the write pulse have significance in making the memristor undergo a resistance transformation, and that linear or log-linear behavior over a relatively wide range of transformed resistances can be achieved.

It is obvious to a person skilled in the art that with the advancement of technology, the basic idea of the invention may be implemented in various ways. As an example, in place of or in addition to pulsed laser deposition also other forms of thin film deposition methods can be used, such as other physical vapor deposition methods, sputtering, chemical vapor deposition, or printing. The invention and its embodiments are thus not limited to the examples described above, instead they may vary within the scope of the claims.

## Claims

1. A memristor (101) comprising a piece of memristor material (301) that constitutes at least one memristive connection between first and second contacts (302, 303), wherein:
- the memristor material has the chemical formula R₍₁₋ₓ₎AₓBO₃, where R is one of Eu, Gd, Tb, Nd; A is one of Ca, Sr, Ba; B is one of Mn, Co, Ni; and x is larger than 0 but smaller than 1,
- said first contact (302) consists predominantly of a first material and said second contact (303) consists predominantly of a second material different from said first material, and
- rectifying properties of a junction between the first material and the memristor material are different from rectifying properties of a junction between the second material and the memristor material;
**characterized in that** the chemical formula of the memristor material is Gd₍₁₋ₓ₎CaₓMnO₃, where x is larger than 0 but smaller than 1.

2. A memristor according to claim 1, wherein x is in one of the following ranges: 0.31-0.99, 0.35-0.99, 0.4-0.98, 0.45-0.97, 0.5-0.96, 0.55-0.95, 0.6-0.95, 0.65-0.95, 0.7-0.95, 0.75-0.95, 0.8-0.95, 0.85-0.95.

3. A memristor according to any of claims 1 or 2, wherein the piece of memristor material constitutes a film on top of a substrate (306), wherein a thickness (d) of the film in a direction perpendicular to a surface of said substrate is between 1 nanometres and 500 nanometres.

4. A memristor according to claim 3, wherein said thickness of the film is between 10 and 100 nanometres.

5. A memristor according to any of claims 1 to 4, wherein the first material is one of: aluminium, titanium.

6. A memristor according to any of claims 1 to 5, wherein the second material is one of: gold, silver, copper, platinum, palladium, indium, SrRuO₃.

7. A memristor according to any of claims 3 to 6, wherein said substrate consists predominantly of one of: strontium titanate SrTiO₃, silicon, lanthanum aluminate - strontium aluminium tantalite (LaAlO₃)_{0.3}(Sr₂TaAlO₆)_{0.7}, LSAT, lanthanum aluminate LaAlO₃, LAO.

8. A microelectronic circuit comprising at least one memristor according to any of claims 1 to 7.

9. A method for manufacturing a memristor (101) comprising a memristor material (301), the method comprising:
- using a material with the chemical formula R₍₁₋ₓ₎AₓBO₃ as said memristor material, where R is one of Eu, Gd, Tb, Nd; A is one of Ca, Sr, Ba; B is one of Mn, Co, Ni; and x is larger than 0 but smaller than 1, and
- producing electrically conductive first and second contacts (302, 303) on at least one surface of the memristor material;
wherein said first contact (302) consists predominantly of a first material and said second contact (303) consists predominantly of a second material different from said first material, and
wherein rectifying properties of a junction between the first material and the memristor material are different from rectifying properties of a junction between the second material and the memristor material;
**characterized in that** the method comprises using Gd₍₁₋ₓ₎CaₓMnO₃ as the memristor material, where x is larger than 0 but smaller than 1.

10. A method according to claim 9, comprising depositing a thin film of said memristor material on top of a substrate (306).

11. A method according to claim 10, comprising using, for said depositing, at least one of:
pulsed laser deposition, other physical vapor deposition, sputtering, chemical vapor deposition, printing.

12. A method according to claim 11, comprising
- producing a dry mixture by mixing a first amount of an oxide of R, a second amount of carbonate of A, and a third amount of an oxide of B,
- pelletizing and calcinating said dry mixture,
- grinding, repelletizing, and sintering into a solid target, and
- using pulsed laser deposition for said depositing, and using said solid target as a target onto which a pulsed laser is focused in said pulsed laser deposition.

13. A method according to any of claims 11 or 12, comprising using a XeCl-laser of wavelength 308 nanometres with energy density of essentially 2 J/cm² and frequency of 5 Hz in said pulsed laser deposition.

14. A method according to claim 13, wherein the deposition temperature is 700 °C and an oxygen partial pressure is essentially 23 Pa in said pulsed laser deposition.

## Patentansprüche

1. Memristor (101), umfassend ein Stück Memristormaterial (301), das mindestens eine memristive Verbindung zwischen ersten und zweiten Kontakten (302, 303) bildet, wobei:
- das Memristormaterial die chemische Formel R₍₁₋ₓ₎AₓBO₃ aufweist, wobei R eines von Eu, Gd, Tb, Nd ist; A eines von Ca, Sr, Ba ist; B eines von Mn, Co, Ni ist und x größer als 0 aber kleiner als 1 ist,
- der erste Kontakt (302) überwiegend aus einem ersten Material besteht und der zweite Kontakt (303) überwiegend aus einem zweiten Material, das von dem ersten Material verschieden ist, besteht, und
- gleichrichtende Eigenschaften eines Übergangs zwischen dem ersten Material und dem Memristormaterial von gleichrichtenden Eigenschaften eines Übergangs zwischen dem zweiten Material und dem Memristormaterial verschieden sind;
**dadurch gekennzeichnet, dass** die chemische Formel des Memristormaterials Gd₍₁₋ₓ₎CaₓMnO₃ ist, wobei x größer als 0 aber kleiner als 1 ist.

2. Memristor gemäß Anspruch 1, wobei x in einem der folgenden Bereiche ist: 0,31-0,99; 0,35-0,99; 0,4-0,98; 0,45-0,97; 0,5-0,96; 0,55-0,95; 0,6-0,95; 0,65-0,95; 0,7-0,95; 0,75-0,95; 0,8-0,95; 0,85-0,95.

3. Memristor gemäß einem der Ansprüche 1 oder 2, wobei das Stück Memristormaterial einen Film oben auf einem Substrat (306) bildet, wobei eine Dicke (d) des Films in einer Richtung, die zu einer Oberfläche des Substrats orthogonal ist, zwischen 1 Nanometer und 500 Nanometern ist.

4. Memristor gemäß Anspruch 3, wobei die Dicke des Films zwischen 10 und 100 Nanometern ist.

5. Memristor gemäß einem der Ansprüche 1 bis 4, wobei das erste Material eines ist von: Aluminium, Titan.

6. Memristor gemäß einem der Ansprüche 1 bis 5, wobei das zweite Material eines ist von: Gold, Silber, Kupfer, Platin, Palladium, Indium, SrRuO₃.

7. Memristor gemäß einem der Ansprüche 3 bis 6, wobei das Substrat überwiegend aus einem von: Strontiumtitanat SrTiO₃, Silizium, Lanthan-Aluminat - Strontium-Aluminium-Tantalit (LaAlO₃)_{0,3} (Sr₂TaAlO₆)_{0,7} , LSAT, Lanthan-Aluminat LaAlO₃, LAO, besteht.

8. Mikroelektronische Schaltung, umfassend mindestens einen Memristor gemäß einem der Ansprüche 1 bis 7.

9. Verfahren zum Herstellen eines Memristors (101), umfassend ein Memristormaterial (301), wobei das Verfahren Folgendes umfasst:
- Verwenden eines Materials mit der chemischen Formel R₍₁₋ₓ₎AₓBO₃ als das Memristormaterial, wobei R eines von Eu, Gd, Tb, Nd ist; A eines von Ca, Sr, Ba ist; B eines von Mn, Co, Ni ist; und x größer als 0 aber kleiner als 1 ist, und
- Produzieren von elektrisch leitenden ersten und zweiten Kontakten (302, 303) auf mindestens einer Oberfläche des Memristormaterials;
wobei der erste Kontakt (302) überwiegend aus einem ersten Material besteht und der zweite Kontakt (303) überwiegend aus einem zweiten Material, das von dem ersten Material verschieden ist, besteht, und
wobei gleichrichtende Eigenschaften eines Übergangs zwischen dem ersten Material und dem Memristormaterial von gleichrichtenden Eigenschaften eines Übergangs zwischen dem zweiten Material und dem Memristormaterial verschieden sind;
**dadurch gekennzeichnet, dass** das Verfahren Verwenden von Gd₍₁₋ₓ₎CaₓMnO₃ als das Memristormaterial umfasst, wobei x größer als 0 aber kleiner als 1 ist.

10. Verfahren gemäß Anspruch 9, umfassend Abscheiden eines dünnen Films des Memristormaterials oben auf einem Substrat (306).

11. Verfahren gemäß Anspruch 10, umfassend Verwenden, für das Abscheiden, von mindestens einem von: gepulster Laserabscheidung, anderer physikalischer Dampfabscheidung, Sputtern, chemischer Dampfabscheidung, Drucken.

12. Verfahren gemäß Anspruch 11, umfassend
- Produzieren einer trockenen Mischung durch Mischen einer ersten Menge eines Oxids von R, einer zweiten Menge von Carbonat von A, und einer dritten Menge eines Oxids von B,
- Pelletieren und Kalzinieren der trockenen Mischung,
- Mahlen, Repelletieren und Sintern zu einem festen Target, und
- Verwenden von gepulster Laserabscheidung für das Abscheiden, und Verwenden des festen Targets als ein Target, auf das ein gepulster Laser in der gepulsten Laserabscheidung fokussiert wird.

13. Verfahren gemäß einem der Ansprüche 11 oder 12, umfassend Verwenden eines XeCl-Lasers einer Wellenlänge von 308 Nanometern mit einer Energiedichte von im Wesentlichen 2 J/cm² und einer Frequenz von 5 Hz in der gepulsten Laserabscheidung.

14. Verfahren gemäß Anspruch 13, wobei die Abscheidungstemperatur 700 °C ist und ein Sauerstoffpartialdruck im Wesentlichen 23 Pa in der gepulsten Laserabscheidung ist.

## Revendications

1. Memristance (101) comprenant un élément de matériau de memristance (301) qui constitue au moins une connexion memristive entre de premier et deuxième contacts (302, 303), dans lequel :
- le matériau de memristance présente la formule chimique R₍₁₋ₓ₎AₓBO₃, où R est l'un parmi Eu, Gd, Tb, Nd ; A est l'un parmi Ca, Sr, Ba ; B est l'un parmi Mn, Co, Ni ; et x est plus grand que 0 mais plus petit que 1,
- ledit premier contact (302) est constitué majoritairement d'un premier matériau et ledit deuxième contact (303) est constitué majoritairement d'un deuxième matériau différent dudit premier matériau, et
- des propriétés de redressement d'une jonction entre le premier matériau et le matériau de memristance sont différentes de propriétés de redressement d'une jonction entre le deuxième matériau et le matériau de memristance ;
**caractérisée en ce que** la formule chimique du matériau de memristance est Gd₍₁₋ₓ₎CaₓMnO₃, où x est plus grand que 0 mais plus petit que 1.

2. Memristance selon la revendication 1, dans laquelle x se situe dans l'une des plages suivantes : 0,31 à 0,99, 0,35 à 0,99, 0,4 à 0,98, 0,45 à 0,97, 0,5 à 0,96, 0,55 à 0,95, 0,6 à 0,95, 0,65 à 0,95, 0,7 à 0,95, 0,75 à 0,95, 0,8 à 0,95, 0,85 à 0,95.

3. Memristance selon l'une quelconque de la revendication 1 ou de la revendication 2, dans laquelle l'élément de matériau de memristance constitue un film sur un substrat (306), dans laquelle une épaisseur (d) du film dans une direction perpendiculaire à une surface dudit substrat est comprise entre 1 nanomètre et 500 nanomètres.

4. Memristance selon la revendication 3, dans laquelle ladite épaisseur du film est comprise entre 10 et 100 nanomètres.

5. Memristance selon l'une quelconque des revendications 1 à 4, dans laquelle le premier matériau est l'un parmi : aluminium et titane.

6. Memristance selon l'une quelconque des revendications 1 à 5, dans laquelle le deuxième matériau est l'un parmi : or, argent, cuivre, platine, palladium, indium et SrRuO₃.

7. Memristance selon l'une quelconque des revendications 3 à 6, dans laquelle ledit substrat est constitué majoritairement de l'un parmi : titanate de strontium SrTiO₃, silicium, aluminate de lanthane - strontium aluminium tantalite (LaAlO₃)_{0.3}(Sr₂TaAlO₆)_{0.7}, LSAT, aluminate de lanthane LaAlO₃, LAO.

8. Circuit microélectronique comprenant au moins une memristance selon l'une quelconque des revendications 1 à 7.

9. Procédé de fabrication d'une memristance (101) comprenant un matériau de memristance (301), le procédé comprenant :
- l'utilisation d'un matériau de formule chimique R₍₁₋ₓ₎AₓBO₃ en tant que ledit matériau de memristance, où R est l'un parmi Eu, Gd, Tb, Nd ; A est l'un parmi Ca, Sr, Ba ; B est l'un parmi Mn, Co, Ni ; et x est plus grand que 0 mais plus petit que 1, et
- la production de premier et deuxième contacts (302, 303) conducteurs électriquement sur au moins une surface du matériau de memristance ;
dans lequel ledit premier contact (302) est constitué majoritairement d'un premier matériau et ledit deuxième contact (303) est constitué majoritairement d'un deuxième matériau différent dudit premier matériau, et
dans lequel les propriétés de redressement d'une jonction entre le premier matériau et le matériau de memristance sont différentes des propriétés de redressement d'une jonction entre le deuxième matériau et le matériau de memristance ;
**caractérisé en ce que** le procédé comprend l'utilisation de Gd₍₁₋ₓ₎CaₓMnO₃ en tant que matériau de memristance, où x est plus grand que 0 mais plus petit que 1.

10. Procédé selon la revendication 9, comprenant le dépôt d'un film mince dudit matériau de memristance sur un substrat (306).

11. Procédé selon la revendication 10, comprenant l'utilisation, pour ledit dépôt, d'au moins un parmi : dépôt par laser pulsé, autre dépôt physique en phase vapeur, pulvérisation cathodique, dépôt chimique en phase vapeur et impression.

12. Procédé selon la revendication 11, comprenant
- la production d'un mélange sec par mélange d'une première quantité d'un oxyde de R, d'une deuxième quantité de carbonate de A, et d'une troisième quantité d'un oxyde de B,
- la granulation et la calcination dudit mélange sec,
- le broyage, une nouvelle granulation, et le frittage en une cible solide, et
- l'utilisation du dépôt par laser pulsé pour ledit dépôt, et l'utilisation de ladite cible solide en tant que cible sur laquelle un laser pulsé est focalisé dans ledit dépôt par laser pulsé.

13. Procédé selon l'une quelconque de la revendication 11 ou de la revendication 12, comprenant l'utilisation d'un laser XeCl de longueur d'onde 308 nanomètres avec une densité d'énergie essentiellement de 2 J/cm² et une fréquence de 5 Hz dans ledit dépôt par laser pulsé.

14. Procédé selon la revendication 13, dans lequel la température de dépôt est de 700 °C et une pression partielle d'oxygène est essentiellement de 23 Pa dans ledit dépôt par laser pulsé.
